# EUROPEAN PATENT SPECIFICATION

(11) **EP 0 801 421 B1**
(45) Date of publication and mention of the grant of the patent: **17.09.2003**
(21) Application number: 96110524.4
(22) Date of filing: 28.06.1996
(51) Int. Cl.: H01L 21/3205, H01L 21/205

(54) **Method for growing hemispherical grain silicon**
Verfahren zum Aufwachsen von Halbkugel-Korn-Silizium
Procédé pour la croissance de silicium à grains hémisphériques

(30) Priority: 25.03.1996 EP 96104723
(43) Date of publication of application: 15.10.1997
(73) Proprietor: UNITED MICROELECTRONICS CORPORATION, Science-Based Industrial Park, Hsinchu City (TW)
(72) Inventor: Yew, Tri-Rung, Chuntung Town, Hsinchu Hsien (TW); Lur, Water, Taipei City (TW); Sun, Shin-Wei, Taipei City (TW)
(74) Representative: Kuhnen & Wacker

(56) References cited:
- US-A- 5 320 880
- MATERIALS LETTERS, vol. 24, no. 1/3, June 1995, AMSTERDAM NL, pages 79-83, XP000512093 XIAODONG LI ET AL.: "Structural characterization of silicon films deposited at low temperature by remote plasma enhanced vapor deposition"
- JAPANESE JOURNAL OF APPLIED PHYSICS, vol. 32, no. 12B/2, 15 December 1993, TOKYO JP, pages L1781-L1783, XP000516969 MASATO HIRAMATSU ET AL.: "The Selective Deposition of a Silicon Film on Hydrogenated Amorphous Silicon by Mercury Sensitized Photochemical Vapor Depositon"
- JAPANESE JOURNAL OF APPLIED PHYSICS, vol. 30, no. 5A/2, 1 May 1991, TOKYO JP, pages L779-L782, XP000237001 MIKIO MOHRI ET AL.: "Very-Low-Temperature Preparation of Poly-Si Films by Plasma Chemical Vapor Deposition Using SiF4/SiH4/H2 Gases"
- SOLID STATE TECHNOLOGY, vol. 35, no. 7, July 1992, WASHINGTON US, pages 29-33, XP000289749 HIROHITO WATANABE ET AL.: "Hemispherical Grain Silicon for High Density DRAMs"
- 1993 SYMPOSIUM ON VLSI TECHNOLOGY - DIGEST OF TECHNICAL PAPERS, May 1993, KYOTO, JAPAN, pages 47-48, XP000462899 K. ANDO ET AL.: "Ultrathin Silicon Nitride Capacitors Fabricated by In Situ Rapid Thermal Multi-Processing for 256 Mb DRAM Cells"

## Description

The present invention relates to a method for depositing at least one layer of hemispherical grained polysilicon (HSG-Si) on or above a silicon substrate according to claim 1.

### Description of the Related Art

From US-A-5,320,880 a method of forming HSG-Si is known, which comprises the steps of providing to a deposition system a substrate having an exposed surface of a semiconductor, generating a plasma region within the deposition system, furthermore providing reactant gases comprising silicon and TiCl₄ to the deposition system so that ions comprising silicon are generated within the deposition system and are transported to the exposed surface.

Historically, increasing the density of integrated circuit devices has been accomplished in part by decreasing the size of the structures such as wiring lines and transistor gate widths and by decreasing the separation between the structures, which make up the integrated circuit device. Reducing the size of circuit structures is generally referred to as decreasing the "design rules" used for the manufacture of the integrated circuit device. For semiconductor memories of the dynamic random access type, i.e. "DRAMS", information is typically stored by varying the amount of charge stored within each capacitor of an array of capacitors formed on the surface of a semiconductor substrate. Most often, a single bit of binary information is stored at each capacitor by associating a discharged capacitor state with a logical zero and a charged capacitor state with a logical one. Each of the memory capacitors within a typical DRAM essentially has a parallel plate structure. The surface area of the plates of the memory capacitor determines the amount of charge that can be stored on the capacitor, given the fixed operating voltage of a typical memory device, the plate separation that can reliably be manufactured, and the dielectric constant of the capacitor dielectric typically used in the capacitors. Reducing the structure size of such a DRAM capacitor in accordance with reduced design rules reduces the surface area of the capacitor plates and therefore has the effect of reducing the amount of charge that can be stored on the memory capacitor.

The plates of memory capacitors typically must be larger than a minimum size to obtain reliable operation of the memory. For recent ultra large scale integration ("ULST") DRAM designs, typical bit line capacitances, sense amplifier sensitivities and noise signals are such that further reductions in the amount of charge stored on the DRAM memory capacitors could prevent the information stored on the capacitor from reliably being read out. In addition, because charge inevitably drains from memory capacitors, DRAMs require the periodic refreshing of the charge stored on the capacitors of the DRAM to ensure that the stored charge remains above the minimum detectable level. Further reductions in capacitor size require more frequent refresh operations for the DRAM, which are undesirable because at least portions of the DRAM are unavailable for the reading and writing of information during refresh operations.

To address the challenges of reduced structure sizes, DRAM designs have been proposed which incorporate capacitors having vertical extensions above the surface of the substrate (*i.e.*, "stacked") or below the surface of the substrate (*i.e.*, "trench"). By adopting a more three-dimensional structure, such DRAM designs provide memory capacitors having larger capacitances but which consume less of the substrate surface area. Although stacked capacitor and trench capacitor designs involve more complicated structures which are more difficult to manufacture, these designs have been adopted with at least some success in recent DRAM designs. Alternative, less expensive and more easily manufactured structures providing improved capacitance memory capacitors are desirable. In addition, it is desirable to reduce the vertical extent of the storage capacitor to allow the production of more planar device structures. There additionally remains a need to increase the capacitance of DRAM storage capacitors while decreasing the amount of surface area consumed by the DRAM storage capacitor on the surface of the semiconductor substrate.

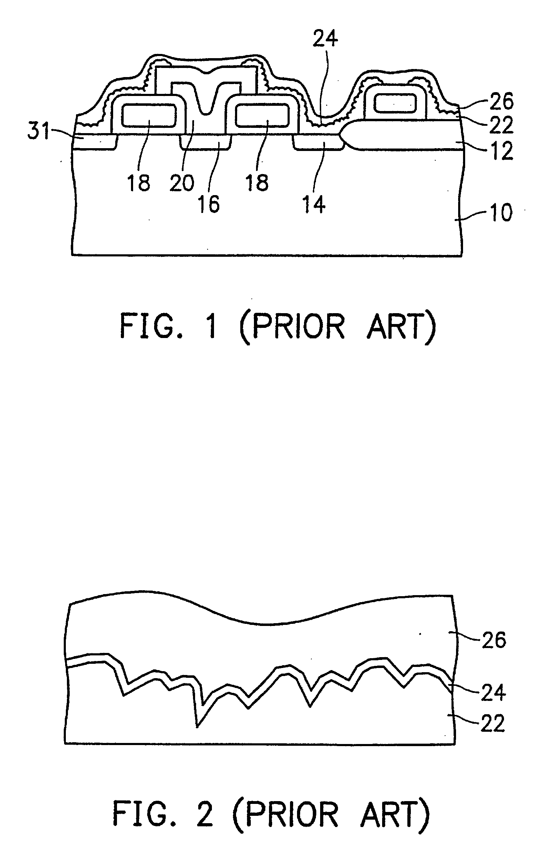

One technique that has been proposed for increasing the capacitance obtained for a fixed substrate surface area is to use rugged or textured polysilicon as the bottom plate for the memory capacitor. The advantages of this technique are illustrated in part in Fig. 1, which shows in cross-section a portion of a DRAM having a memory capacitor with a lower plate electrode formed from textured polysilicon. The illustrated DRAM consists of a silicon substrate 10, field oxidation region 12, drain region 14 and source region 16. Word lines 18 typically act as the gates of transfer field effect transistors ("FETs") and bit line 20 contacts the heavily doped source region common to the two illustrated FETs. In such a DRAM structure, the memory capacitor is connected to the drain 14 of the transfer FET to store the charge which corresponds to the information stored in that memory cell. A layer of textured polysilicon is used as the lower electrode 22 for the capacitor, a thin dielectric layer 24 covers the surface of the lower electrode 22, and cell plate 26 is formed on the dielectric layer 24 to serve as the upper electrode for the capacitor. By using textured polysilicon as the lower electrode of the capacitor, the surface area of the capacitor is increased without extending the capacitor electrodes laterally, so that the illustrated structure has improved capacitance for a fixed surface area.

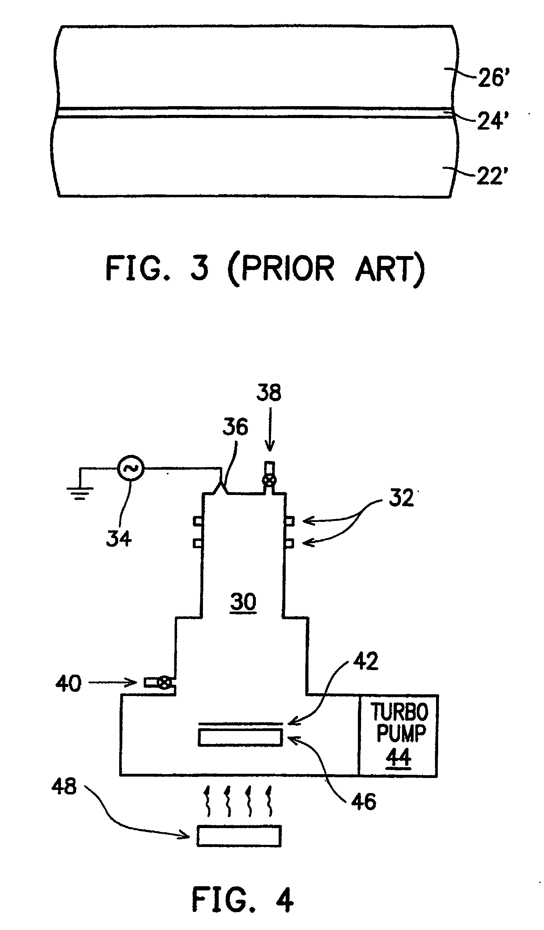

A comparison between the memory capacitors shown in partial cross-section in Figs. 2 and 3 further illustrates the advantage of utilizing a textured polysilicon layer as the lower electrode of a memory capacitor. Like reference numerals are used in Figs. 1-3 to identify the same or similar structures for ease in understanding this discussion. Referring to Fig. 2, the lower electrode 22 is formed in such a fashion that it has a textured surface. The thin dielectric layer 24 should be sufficiently thin so that the texture of the lower electrode 22 is reproduced on the surface of the dielectric layer 24 and the lower surface of the upper electrode 26 runs parallel to the surface of the lower electrode 22. Comparing Fig. 2 to the Fig. 3 planar capacitor structure consisting of lower electrode 22', dielectric layer 24' and upper electrode 26', it can be appreciated that the electrodes of the structure of Figs. 1-2 have larger surface areas than do the electrodes 22' and 26' of the Fig. 3 planar structure. Capacitors utilizing the Fig. 2 structure have been observed to have capacitances more than two times larger than corresponding Fig. 3 capacitors which occupy the same surface area on the substrate.

A variety of techniques have been used to produce textured polysilicon for use in semiconductor devices like the DRAM illustrated in Figs. 1-2. Watanabe, et al., "Device Application and Structure Observation for Hemispherical-Grained Si," J. Appl. Physics, vol. 71, No. 7, Apr. 1992, pp. 3538-3543 describes the formation of hemispherical-grained polycrystalline silicon ("HSG Si", the term frequently used to refer to textured polysilicon) by low pressure chemical vapor deposition (LPCVD) from silane gas (SiH,). The surface roughness or texture of the HSG-Si films was optimized so that the HSG-Si films could be used as plates of DRAM memory capacitors. Acceptable levels of surface texture, determined by the increased electrode surface area for fixed substrate area desirable for memory capacitors, were obtained for material deposited at a substrate temperature of 590°C. Substrate deposition temperatures of ten degrees higher or lower than 590°C produced an unacceptable surface texture, that is, these conditions produced an undesirably flat surface which did not have appreciably larger surface area than conventional polysilicon. Capacitors made using a lower electrode of HSG-Si deposited using LPCVD onto a substrate maintained at a temperature of 590°C exhibited a capacitance per unit substrate area approximately two times larger than similar capacitors made using HSG-Si lower electrodes deposited at substrate temperatures of either 580°C or 600°C. Accordingly, while LPCVD at 590°C produces HSG-Si having desirable surface texture characteristics for use as a DRAM storage capacitor, careful control of the deposition conditions is necessary to achieve the desired results.

Fazan, et al., "Electrical Characterization of Textured Interpoly Capacitors for Advanced Stacked DRAMs," IEDM, IEEE 1990, pp. 663-666 describes an alternative process for forming a textured surface on a layer of doped polycrystalline silicon. Wet oxidation at 907°C is used to grow an oxide film on the surface of a doped polysilicon layer and then the oxide film is etched to produce a textured. surface on the polycrystalline silicon. Etching of the oxide layer grown on the polysifcon layer results in creation of a textured polysilicon surface due to the greater levels of oxidation that occurs along the grain boundaries of doped polysilicon layers coupled with the subsequent removal of the oxide from the polysilicon grain boundaries. The extent of surface roughness produced in this process directly relates to the size of the polysilicon grains, so that small grained films are required to produce desirable levels of surface texture. Accordingly, it is preferred in this technique to utilize thin polysifcon films, which tend to have smaller grain sizes than thicker polysilicon films. Such thin poiysilicon films, however, often have undesirably high resistance and are not particularly strong. The technique described in the Kazan article has the further disadvantage of requiring oxidation and etching steps beyond the steps of depositing the polysilicon layer. It would be desirable to grow HSG-Si using a simpler technique that allowed the use of thicker layers of polysilicon as part of the electrode structure.

Another technique utilized for growing polysilicon proceeds by depositing a layer of amorphous silicon having a planar surface. The surface of the amorphous silicon layer is cleaned to remove the native oxide from the surface of the amorphous silicon, and then seed crystal sites (i.e., nucleation sites) are formed on the cleaned surface by molecular beam deposition. Subsequent annealing of the structure in an ultra-high vacuum environment causes crystallites to grow from the seed crystal positions, so that the amorphous silicon layer is converted into a layer of silicon having HSG-Si on its surface. An early report on this technique is the article by Sakai, A. et al., "Growth Kinetics of Si Hemispherical Grains on Clean Amorphous-Si Surfaces" J. Vac. Sci. Technol. A, American Vacuum Society, vol. 11, Nov./Dec. 1993, pp. 2950-2953. This technique has the disadvantage of requiring ultra-high vacuum for the molecular beam deposition and the annealing steps. Typically, moving wafers in and out of such ultra-high vacuum environments takes more time than wafer transport through more conventional processing environments, and so the use of such ultra-high vacuum environments limits the applicability of this method. It would therefore be desirable to provide a method of manufacturing textured polysilicon which is more simply manufactured.

### Summary of the Preferred Embodiments

The present invention provides a method for depositing at least one layer of hemispherical grained polysilicon (HSG-Si) on or above a silicon substrate, comprising the steps of:
depositing a layer of polysilicon on a silicon substrate;
providing an exposed surface on the layer of polysilicon substantially free of native oxides ;
introducing the silicon substrate to a plasma deposition system;
plasma depositing at least one layer of HSG-Si on said exposed surface by maintaining the silicon substrate at a temperature below about 590°C;
providing a reactant gas comprising only SiH₄, H₂ and argon and wherein the dilution rate SiF₄/(SiH₄ + H₂) is in the range of 70-99% so as to provide a reactant gas which is excited to provide ions comprising silicon to the deposition system; and
transporting the ions comprising silicon to the exposed surface of the layer of polysilicon and depositing said at least one layer of HSG-Si.

Improved embodiments of the inventive method result from the subclaims 2 to 16.

### Brief Description of the Drawings.

Fig. 1 illustrates in cross-section a portion of a DRAM utilizing a memory capacitor having a lower electrode incorporating a lower electrode of hemispherical grained silicon.
Fig. 2 illustrates an enlarged view of a portion of the Fig. 1 structure.
Fig. 3 illustrates for comparison a capacitor section similar to that illustrated in Fig. 2, but utilizing a planar capacitor structure.
Fig. 4 illustrates a electron cyclotron resonance chemical vapor deposition system which may be used for the plasma deposition of textured polysilicon.
Fig. 5 is a cross-sectional photomicrograph of a textured polysilicon layer formed in accordance with the present invention.
Figs. 6-8 illustrate the formation of a flash memory cell formed using aspects of the present invention.

### Description of the Preferred Embodiments.

Preferred embodiments of the present invention can be used to deposit layers of hemispherical grained polysilicon (HSG-Si) suitable for use in forming memory capacitors in DRAM structures such as that illustrated in Fig. 1. HSG-Si layers formed in accordance with the present invention can also be used in other semiconductor memory devices, or in other devices whose performance can be improved by providing increased capacitances without increasing the lateral extent of the capacitor. Particularly preferred embodiments of the present invention deposit HSG-Si from a gaseous mixture consisting of excited ions, such as a plasma. Deposition of polysilicon in accordance with preferred embodiments of the invention readily produces HSG-Si having desirable levels of surface texture over a broader range of processing conditions than can be used in the LPCVD deposition of HSG-Si. In addition, deposition of HSG-Si in accordance with preferred embodiments of the present invention can be performed as a simple modification of the conventional planar polysilicon deposition process, and so represents a less complicated process than either the process which includes the etching of doped polysilicon (Fazan, et al.), or the process which includes molecular beam deposition of seed crystals and subsequent annealing in an ultra-high vacuum environment.

Plasma deposition of HSG-Si in accordance with preferred embodiments of the present invention can be performed at a wider range of substrate deposition temperatures than can be used in the LPCVD deposition of HSG-Si. To deposit HSG-Si having the desired surface texture using LPCVD, it is necessary to maintain the substrate at the target deposition temperature to an accuracy of±3°C. By contrast, HSG-Si having desirable surface texture characteristics has, for example, been plasma deposited at substrate temperatures between 200°C to 500°C. The more relaxed constraints on process variables provided using the methods of the present invention make the deposition of HSG-Si more reliable both in wafer uniformity and in wafer to wafer reproducibility. The significant benefits associated with the use of plasma deposition are believed to be related to the fact that plasma deposition generates many distinct nucleation sites from which silicon crystallites grow during the deposition process.

In the LPCVD deposition of HSG-Si, the very narrow range of substrate deposition temperatures reflects the limited range in which a sufficient level of nucleation and crystallite growth occurs without the occurrence of significant levels of surface reconstruction. Nucleation in the LPCVD process is believed to be primarily a thermal process, so that sufficiently high temperatures must be maintained for deposition to occur. On the other hand, temperatures only slightly higher than the target substrate temperature for LPCVD deposition of HSG-Si are sufficient to allow substantial levels of mobility for the silicon atoms at the growth surface, thereby allowing surface reconstruction during the LPCVD deposition of HSG-Si. Increasing the substrate deposition temperature by only a small amount above the minimum temperature for LPCVD growth results in the planarization of the surface, rather than in the growth of independent crystallites, due to the increased mobility of atoms during deposition. It is accordingly necessary to maintain the substrate temperature for LPCVD above the nucleation temperature but below the temperature where surface mobility significantly impedes the development of a textured surface. By contrast, in the plasma deposition of HSG-Si, the deposition substrate is preferably maintained at lower temperatures at which there is little mobility of silicon atoms at the deposition surface. Nucleation sites are generated at the deposition surface from the deposition gases in a manner that is relatively independent of the substrate temperature. Growth of HSG-Si crystallites appears to be controlled by the excitation of the reactant gases so that, for sufficiently high growth rates, crystallites grow independently over a broad range of substrate temperatures. Thus, plasma deposition of HSG-Si can be successfully performed at a wider range of substrate deposition temperatures as compared to the LPCVD of HSG-Si.

For definitional purposes, the LPCVD of HSG-Si can be viewed as a process that is primarily controlled by the thermal conditions of the deposition substrate, while plasma deposition is a process primarily controlled by the excitation level of the reactant gases.

LPCVD of HSG-Si is generally performed on amorphous silicon surfaces. This is because LPCVD on a polysilicon surface will generally result in the continued growth of crystallites existent on the surface of the polysilicon layer, rather than in the growth of a textured surface. By contrast, HSG-Si can be formed by plasma deposition on polysilicon due to the nature of the nucleation process in plasma deposition, which is generally not in thermal equilibrium with the silicon surface on which the deposition is being performed. Use of polysilicon as the layer underlying the HSG-Si layer is preferred for most applications in which an HSG-Si surface is desirable, because most such applications required good conductivity and polysilicon possesses superior conductivity characteristics as compared to amorphous silicon.

To facilitate the nucleation of seed crystallites in the initial phase of plasma deposition of HSG-Si, it is preferred that the growth process be initiated on a clean silicon surface. The growth process is be initiated on a polysilicon layer, which may be doped or undoped. Certain embodiments of the present invention utilize a layer of polycrystalline silicon deposited by LPCVD from silane at a temperature of about 620°C. The surface of the polycrystalline silicon layer is cleaned of native oxide before the HSG-Si plasma deposition process begins. A distinct cleaning step may be unnecessary if the growth of the HSG-Si layer is initiated immediately after forming the underlying layer of silicon, if the surface of the underlying silicon layer is maintained in a sufficient vacuum to prevent oxide growth. More practically, it is to be expected that there will be a time interval between the growth of the underlying silicon layer and the initiation of HSG-Si growth. Thus, a thin layer of native oxide will typically form on the surface of the underlying silicon layer. The presence of even a thin layer of native oxide may significantly hinder the nucleation of independent crystallite growth in the manner preferred for the present invention. Accordingly, the surface of the underlying silicon layer is cleaned before the initiation of HSG-Si growth.

Native oxides may be cleaned from the surface of polysilicon or amorphous silicon by a variety of techniques, including HF dip, spin-etching using HF, vapor HF cleaning, or by an H₂ plasma cleaning. Preferably, the surface of the underlying silicon layer is hydrogenated as a result of the cleaning operation, because the hydrogenated surface serves to protect the polysilicon surface from reoxidation. Each of the cleaning techniques listed above will achieve the desired hydrogenation of the polysilicon surface.

After the surface of the underlying silicon layer has been prepared, HSG-Si is grown using a plasma deposition process. As used herein, the term "plasma deposition" is used to refer to a variety of techniques that can be used for creating a gas of highly excited atomic or molecular species that, through any of a variety of deposition processes, are deposited on a substrate. Well known and commonly practiced examples of such plasma deposition techniques include radio frequency (RF) sputtering, direct current (DC) sputtering, electron cyclotron resonance chemical vapor deposition (ECR-CVD), microwave chemical vapor deposition, and plasma enhanced chemical vapor deposition (PECVD) or RF-CVD. Although testing of the various plasma deposition methods has not been undertaken, the present inventors believe that each of these techniques will provide acceptable results for the growth of HSG-Si. Deposition proceeds through the establishment of nucleation sites on the surface of the polysilicon or other desired deposition surface, and then the processing conditions such as substrate temperature and reactant flow rate are controlled so as to grow the silicon crystallites at a sufficient rate so as to prevent surface reconstruction during growth. The processing conditions for the growth of HSG-Si are chosen so as to emphasize the independent growth of crystallites at the growth surface of the polysilicon, thereby limiting the extent to which adjacent crystallites can grow together. To a certain extent, the particular process conditions that are optimum for the growth of HSG-Si will be determined by the particular system used for deposition, as is well known in the art of plasma deposition.

In certain preferred embodiments of the present invention, an ECR-CVD system such as that illustrated in Fig. 4 is used for the deposition of HSG-Si. An ECR-CVD deposition system provides the advantages of highly efficient excitation of reactants without the generation of high energy ions which can damage the substrate or the material being deposited. Microwave energy is generated by power supply 34 and may be provided to the system through an antenna 36 mounted so as to direct energy through the excitation region 30. Input power levels between 100-1500 W were used for successfully depositing HSG-Si films having desired levels of surface roughness. Magnetic coils 32 are situated around the excitation region 30 to generate the magnetic field necessary to establish the ECR condition within the excitation region 30. For microwaves supplied to the excitation region at a frequency of 2.45 GHz, the conditions for cyclotron resonance are satisfied by the presence of a magnetic field of approximately 875 Gauss. Typically, the magnetic coils 32 have a quadrupole or octopole configuration so that the appropriate magnetic field is generated over a limited region, and the field drops off quickly outside of that region. Thus, reactant excitation is primarily localized within a small region displaced away from the deposition substrate 42.

Reactant gases are input to the ECR-CVD system either at an inlet 38 upstream from the excitation region 30 or at an inlet 40 downstream from the excitation region. For the deposition of HSG-Si, a suitable input gas configuration is to input hydrogen gas (H₂) at the upstream gas inlet 38 and input a mixture of 5% silane (SiH₄) and 95% argon (Ar) at the downstream gas inlet 40. Turbomolecular pump 44 draws gas from the system, creating a gas flow from the gas inlets 38, 40 past the deposition substrate 42. Gas pressure can be varied within the range of between 0,6666-7,999 N/m² (5-60 mTorr), without affecting the quality of HSG-Si films deposited. Hydrogen flows from inlet 42 through the excitation region 30 where the hydrogen is highly ionized. Silane input at the downstream inlet 40 interacts with the excited hydrogen ions and with the input microwave radiation, so that the silane is excited and ionized. The silicon ions interact with and are deposited on the surface of the deposition substrate 42.

The deposition substrate 42, which is typically a silicon wafer at an intermediate stage of device formation, is typically placed on a susceptor 46 which maintains a constant temperature during deposition. The susceptor 46 may be heated by, for example, an infrared light source 48. In particularly preferred embodiments of the present invention, the substrate temperature is maintained at a sufficiently low temperature so that silicon atoms at the surface have relatively low levels of mobility. As discussed above, for HSG-Si deposition in accordance with a preferred embodiment of the present invention, there is no need to maintain the deposition substrate at a sufficiently high temperature to cause thermal nucleation at the,surface of the silicon surface of the deposition substrate. Temperatures ranging between 200-500°C were utilized in the inventors' experiments in growing HSG-Si layers having desired levels of surface texture.

The dilution level of the reaction gases appeared to have the greatest effect on the texture of the HSG-Si deposited in accordance with preferred embodiments of the present invention. Silicon atoms should be provided to the surface of the deposition substrate at a suffciendy high rate that little surface reconstruction can occur, so that surface texture can develop during deposition. Too high a dilution (i.e., too much hydrogen gas input to the system) results in the deposition of an amorphous film. In the illustrated embodiment using a particular configuration of an ECR-CVD system, the dilution ratio H₂/(SiH₄+H₂) is preferably maintained in the range from 70-99%.

Often, HSG-Si layers are used on the surface of electrodes that are coated with a thin layer of dielectric material and a layer of conductive material, where the HSG-Si electrode layer is capacitively coupled to the conductive layer. It is typically desirable for such electrodes incorporating a layer of HSG-Si to be highly conductive. To this end, the HSG-Si layer can be doped by ion implantation, diffusion, or by *in situ* doping during the plasma deposition. *In situ* doping during plasma deposition is particularly preferred because of the ease by which dopants may be incorporated into a layer of HSG-Si during plasma deposition. In addition, by *in* situ *doping the HSG-Si layer, the exposed surface of the HSG-Si need not be* exposed to further heat treatments to anneal an implantation or to drive a diffusion process. Such heat treatments could undesirably alter the texture of the exposed HSG-Si surface. Preferably, any heat treatments subsequent to the formation of the HSG-Si layer are conducted after the surface of the HSG-Si layer has been stabilized by the formation of, for example, an appropriate dielectric layer on the surface. *In situ* doping may be accomplished, for example, by introducing borane, diborane, arsine or phosphine into the downstream gas inlet of the ECR-CVD system illustrated in Fig. 4 during the deposition of the HSG-Si layer.

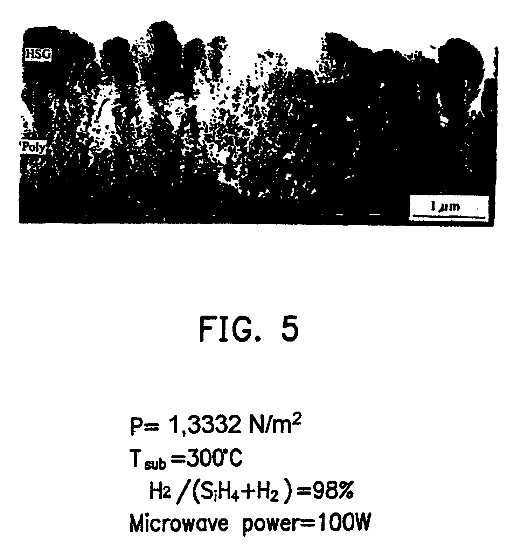

Fig. 5 is a cross-sectional micrograph of HSG-Si deposited in accordance with the present invention. The illustrated HSG-Si layer was deposited on the cleaned,surface of a layer of polysilicon. The layer of HSG-Si was deposited at a total gas pressure 1,3332 N/m² (10 mTorr), a dilution ratio H₂/(SiH₄+H₂) = 98%, a substrate temperature of 300°C and 100 W of input microwave power. It is apparent from the Fig. 5 micrograph that a substantial level of texture has been introduced during the deposition of this layer of HSG-Si, with surface structures on the order of one micron being formed in the deposition process. When the surface of a structure such as that illustrated in Fig. 5 is coated with a thin dielectric layer and an upper layer of conductive material is deposited on the dielectric layer, a high capacitive coupling can be established between the HSG-Si layer and the upper layer of conductive material. For such a structure, it is desirable to use a dielectric layer that is thin in comparison to the scale of the texture on the surface. For the layer illustrated in Fig. 5, which has surface structures approaching one micron in size, it would be desirable to use a dielectric layer that is less than about fifty nanometers thick. It is also desirable to form the dielectric layer from a material having a high dielectric constant. An appropriate dielectric layer can be formed by depositing a layer of silicon nitride on the surface of the HSG-Si layer, for example by CVD, and then growing a thin oxide layer on the surface of the silicon nitride layer. Often, such an "NO" layer is formed on top of an oxide layer, such as a native oxide layer, covering the surface of the HSG-Si layer, so that the actual dielectric film formed has an "ONO" structure. According to Rosato, et al., "Ultra-High Capacitance Nitride Films Utilizing Surface Passivation on Rugged Polysilicon," J. Electrochem. Soc., Vol. 139, No. 12, pages 3678-82 (Dec. 1992), such an "ONO" structure can be formed to a thickness of approximately 20 nanometers. The teachings of the Rosato article, including the teachings regarding the formation of ONO dielectric layers on rugged polysilicon and on the passivation of native oxide surfaces before the deposition of a CVD nitride layer, are hereby incorporated by reference.

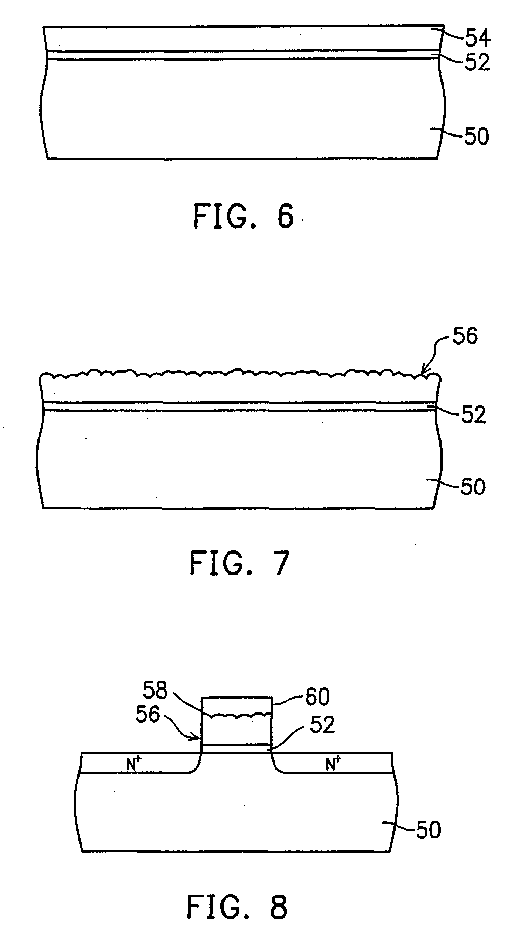

While the method for depositing HSG-Si has been described herein with specific reference to forming a capacitor such as that shown in the DRAM structure of Fig. 1, HSG-Si deposited in accordance with the present invention can be utilized in other structures. For example, HSG-Si can be used on the surface of the floating gate in an EEPROM or a flash memory. Use of an HSG-Si surface and a thin ONO dielectric layer between a polysilicon floating gate and a polycide control gate formed over the ONO dielectric layer greatly improves the coupling between the floating gate and the control gate as compared to more conventional flash memory device structures. Figs. 6-8 illustrate the formation of such a structure.

Referring to Fig. 6, a flash memory may be formed on a P-type silicon substrate 50 by first growing a thin thermal gate oxide 52 and then depositing a thin layer of polysilicon 54. Depending on the particular sequence and timing of the layer formation, the surface of the polysilicon may be coated with a thin layer of thermal oxide, which is removed before HSG-Si is grown on the polysilicon layer 54. The thermal oxide may be removed, for example, by spin-etching using hydrogen fluoride (HF). More particularly, HF is sprayed onto the surface of the Fig. 6 deposition substrate while the substrate is being spun rapidly. The surface is then rinsed, while still spinning the substrate, first with ethanol (C₂H₃OH) and then with deionized water. The surface of the Fig. 6 deposition substrate will have its thermal oxide layer removed, and the surface of the exposed polysilicon layer 54 will be hydrogenated to protect the surface from the immediate formation of another native oxide layer. A layer of HSG-Si is then deposited, preferably in an ECR-CVD system such as that illustrated in Fig. 4, producing the polysilicon and HSG-Si layer structure 56 illustrated in Fig. 7. Preferably, at least the HSG-Si surface layer is doped by *in situ* doping during the plasma deposition process. A layer of CVD silicon nitride is then deposited on the surface of layer 56 and the nitride is oxidized to produce NO or ONO dielectric layer 58. A conductive layer 60 of, for example, polycide is formed on the dielectric layer 58, the gate electrode is patterned and defined by etching, and source and drain regions are formed by doping to form the partial structure illustrated in Fig. 8. Further processing is performed to complete the flash memory device.

## Claims

1. A method for depositing at least one layer of hemispherical grained polysilicon (HSG-Si) on or above a silicon substrate, comprising the steps of:
depositing a layer of polysilicon on a silicon substrate;
providing an exposed surface on the layer of polysilicon substantially free of native oxides;
introducing the silicon substrate to a plasma deposition system;
plasma depositing at least one layer of HSG-Si on said exposed surface by maintaining the silicon substrate at a temperature below about 590°C;
providing a reactant gas comprising only SiH₄, H₂ and argon and wherein the dilution rate SiH₄/(SiH₄ + H₂) is in the range of 70-99% so as to provide a reactant gas which is excited to provide ions comprising silicon to the deposition system; and
transporting the ions comprising silicon to the exposed surface of the layer of polysilicon and depositing said at least one layer of HSG-Si.

2. The method of claim 1, wherein the deposition system is an electron cyclotron resonance deposition chemical vapor deposition system having a gas flow path extending from a first gas inlet through a reactant gas excitation region to a deposition area gas output connected to a pumping system.

3. The method of claim 2, wherein the substrate is positioned downstream along the gas flow path from the reactant gas excitation region.

4. The method of claim 3, wherein the deposition system includes a second gas inlet along the gas flow path between the plasma region and the substrate.

5. The method of claim 4, wherein the reactant gas comprising silicon is introduced to the deposition system at the second gas inlet during the step of depositing the layer of HSG-Si.

6. The method of claim 1, wherein the exposed surface is hydrogenated before the silicon substrate is provided to the deposition system.

7. The method of claim 1, wherein the exposed surface is cleaned using hydrogen fluoride.

8. The method of claim 1, wherein the silicon substrate is maintained at a temperature between about 200-500°C.

9. The method of claim 1, wherein the deposition system is operated to a total pressure of between about 0,6666-7,999 N/m² (5-60 mTorr).

10. The method of claim 1, further comprising the step of forming a dielectric layer of less than fifteen nanometers thickness on the surface of the HSG-Si layer.

11. The method of claim 1, further comprising the step of depositing a layer of silicon nitride on the surface of the HSG-Si layer.

12. The method of claim 11, further comprising the steps of forming an oxide on the silicon nitride layer and then forming a layer of a conductive material over the oxide layer.

13. The method of claim 11, wherein the layer of silicon nitride is deposited on a native oxide layer formed on the surface of the HSG-Si layer.

14. The method of claim 12, wherein the conductive layer comprises polysilicon.

## Patentansprüche

1. Verfahren zum Niederschlagen von wenigstens einer Schicht aus kömigem halbkugelförmigen Polysilizium (HSG-Si) auf oder über einem Siliziumsubstrat, mit den folgenden Schritten:
Niederschlagen einer Schicht aus Polysilizium auf einem Siliziumsubstrat;
Erzeugen einer freiliegenden Fläche auf der Schicht aus Polysilizium, die im wesentlichen frei von ursprünglichen Oxiden ist;
Einbringen des Siliziumssubstrats in ein Plasma-Niederschlagssystem;
Plasma-niederschlagen von wenigstens einer Schicht aus HSG-Si auf der freigelegten Fläche indem das Siliziumsubstrat auf einer Temperatur unterhalb von etwa 590° C gehalten wird;
Zuführen eines Reaktanzgases, welches lediglich SiH₄, H₂ und Aragon enthält und wobei die Verdünnungsrate SiH₄/(SiH₄ + H₂) in dem Bereich von 70 bis 99% liegt, um dadurch ein Reaktanzgas vorzusehen, welches erregt werden kann, um in dem Niederschlagsystem Ionen zu erzeugen, die Silizium aufweisen; und
Transportieren der Ionen, die Silizium enthalten, zu der freigelegten Fläche der Schicht aus Polysilizium und Niederschlagen der wenigstens einen Schicht aus HSG-Si.

2. Verfahren nach Anspruch 1, bei dem das Niederschlagssystem aus einem chemischen Dampfniederschlagssystem für einen Elektronen-Zyklotron-Resonanz-Niederschlagsvorgang besteht, welches einen Gasströmungspfad aufweist, der sich von einem ersten Gaseinlass durch eine Reaktanzgas-Erregungszone zu einem Niederschlagsbereich entsprechend einem Gasauslass erstreckt, der mit einem Pumpsystem verbunden ist.

3. Verfahren nach Anspruch 2, bei dem das Substrat entlang dem Gasströmungspfad stromabwärts von der Reaktanzgas-Erregungszone positioniert ist.

4. Verfahren nach Anspruch 3, bei dem das Niederschlagssystem entlang dem Gasströmungspfad einen zweiten Gaseinlass enthält und zwar zwischen der Plasmazone und dem Substrat.

5. Verfahren nach Anspruch 4, bei dem das Reaktanzgas Silizium enthält und in das Niederschlagssystem an dem zweiten Gaseinlass während des Schrittes des Niederschlagens der Schicht aus HSG-Si eingeleitet wird.

6. Verfahren nach Anspruch 1, bei dem die freigelegte Fläche hydriert wird bevor das Siliziumsubstrat in das Niederschlagssystem eingebracht wird.

7. Verfahren nach Anspruch 1, bei dem die freigelegte Fläche unter Verwendung von Wasserstoff-Fluorid gereinigt wird.

8. Verfahren nach Anspruch 1, bei dem das Siliziumsubstrat auf einer Temperatur zwischen etwa 200-500 °C gehalten wird.

9. Verfahren nach Anspruch 1, bei dem das Niederschlagssystem gemäß einem Gesamtdruck zwischen etwa 0,6666-7,999 N/m² (5 - 60 mTorr) betrieben wird.

10. Verfahren nach Anspruch 1, femer mit einem Schritt gemäß der Ausbildung einer dielektrischen Schicht mit einer Dicke kleiner als 15 nm auf der Oberfläche der HSG-Si Schicht.

11. Verfahren nach Anspruch 1, ferner mit einem Schritt gemäß Niederschlagen einer Schicht aus Siliziumnitrid auf der Oberfläche der HSG-Si Schicht.

12. Verfahren nach Anspruch 11, ferner mit den Schritten gemäß Ausbilden eines Oxids auf der Siliziumnitridschicht und dann Ausbilden einer Schicht aus einem leitenden Material über der Oxidschicht.

13. Verfahren nach Anspruch 11, bei dem die Schicht aus Siliziumnitrid auf einer ursprünglichen Oxidschicht ausgebildet wird, die auf der Oberfläche der HSG-Si Schicht ausgebildet ist.

14. Verfahren nach Anspruch 12, bei dem die leitende Schicht Polysilizium enthält.

## Revendications

1. Procédé de dépôt d'au moins une couche de polysilicium à grains hémisphériques (HSG-Si) sur ou au-dessus d'un substrat en silicium, comprenant les étapes consistant à :
déposer une couche de polysilicium sur un substrat de silicium ;
fournir une surface exposée sur la couche de polysilicium essentiellement dépourvue d'oxydes natifs ;
introduire le substrat de silicium dans un système de dépôt par plasma ;
déposer par plasma au moins une couche de HSG-Si sur ladite surface exposée en maintenant le substrat de silicium à une température en dessous d'environ 590° C ;
fournir un gaz réactif ne comprenant que du SiH₄, H₂ et argon et dans lequel le taux de dilution SiH₄/(SiH₄ + H₂) est dans la gamme de 70 à 99 % de façon à fournir un gaz réactif qui est excité pour fournir des ions comprenant du silicium au système de dépôt ; et
transporter les ions comprenant dû silicium vers la surface exposée de la couche de polysilicium et déposer au moins ladite couche de HSG-Si.

2. Procédé selon la revendication 1, dans lequel le système de dépôt est un système de dépôt chimique en phase vapeur à résonance de cyclotron électronique ayant un trajet d'écoulement de gaz s'étendant depuis un premier orifice d'entrée de gaz à travers une région d'excitation de gaz réactif vers une sortie de gaz d'aire de dépôt reliée à un système de pompage.

3. Procédé selon la revendication 2, dans lequel le substrat est positionné en aval le long du trajet d'écoulement de gaz depuis la région d'excitation de gaz réactif.

4. Procédé selon la revendication 3, dans lequel le système de dépôt inclut un second orifice d'entrée de gaz le long du trajet d'écoulement de gaz entré la région de plasma et le substrat.

5. Procédé selon la revendication 4, dans lequel le gaz réactif comprenant du silicium est introduit au système de dépôt au niveau du second orifice d'entrée de gaz pendant l'étape de dépôt de la couche de HSG-Si.

6. Procédé selon la revendication 1, dans lequel la surface exposée est hydrogénée avant que le substrat de silicium ne soit fourni au système de dépôt.

7. Procédé selon la revendication 1, dans lequel la surface exposée est nettoyée en utilisant du fluorure d'hydrogène.

8. Procédé selon la revendication 1, dans lequel le substrat de silicium est maintenu à une température entre environ 200 à 500° C.

9. Procédé selon la revendication 1, dans lequel le système de dépôt est mis en oeuvre à une pression totale d'entre environ 0,6666 à 7,999 N/m² (5 à 60 mTorr).

10. Procédé selon la revendication 1, comprenant, en outre, l'étape de formation d'une couche diélectrique de moins de quinze nanomètres d'épaisseur sur la surface de la couche HSG-Si.

11. Procédé selon la revendication 1, comprenant, en outre, l'étape de dépôt d'une couche de nitrure de silicium sur la surface de la couche HSG-Si.

12. Procédé selon la revendication 11, comprenant, en outre, les étapes de formation d'un oxyde sur la couche de nitrure de silicium, puis de formation d'une couche de matériau conducteur sur la couche d'oxyde.

13. Procédé selon la revendication 11, dans lequel la couche de nitrure de silicium est déposée sur une couche d'oxyde natif formée sur la surface de la couche HSG-Si.

14. Procédé selon la revendication 12, dans lequel la couche conductrice comprend du polysilicium.
